# EUROPÄISCHE PATENTSCHRIFT

(11) **EP 3 231 073 B1**
(45) Veröffentlichungstag und Bekanntmachung des Hinweises auf die Patenterteilung: **24.03.2021**
(21) Anmeldenummer: 15787515.4
(22) Anmeldetag: 21.10.2015
(51) Int. Cl.: H02K 41/03

(54) **SICHERUNGSSYSTEM FÜR EINE ANORDNUNG ZUM BEWEGEN VON TRANSPORTKÖRPERN**
SAFETY SYSTEM FOR AN ASSEMBLY FOR MOVING TRANSPORT BODIES
SYSTÈME DE PROTECTION D'UN DISPOSITIF DE DÉPLACEMENT D'ÉLÉMENTS DE TRANSPORT

(30) Priorität: 08.12.2014 DE 102014225171
(43) Veröffentlichungstag der Anmeldung: 18.10.2017
(73) Patentinhaber: Robert Bosch GmbH, 70442 Stuttgart (DE)
(72) Erfinder: PAWELETZ, Anton, 70736 Fellbach (DE); HANISCH, Markus, 71706 Markgroeningen (DE); GRAN, Sebastian, 35452 Heuchelheim (DE); WINDSHEIMER, Joshua, 74589 Satteldorf (DE); RAATZ, Heike, 70372 Stuttgart (DE)
(86) Internationale Anmeldenummer: PCT/EP2015/074380
(87) Internationale Veröffentlichungsnummer: WO 2016/091441

(56) Entgegenhaltungen:
- EP-A2- 2 365 617
- WO-A1-2013/059934

## Beschreibung

### Stand der Technik

Die vorliegende Erfindung betrifft ein Transportsystem sowie ein System zur Bewegung permanentmagnet-erregter Transportkörper. Insbesondere betrifft die vorliegende Erfindung eine automatische Bremsung der Transportkörper im Falle einer Unterbrechung einer elektrischen Energieversorgung, wobei das Ziel eine fixe lokale Anordnung der Transportkörper zur Bremsung des Transportkörpers unter Levitation erfolgt.

Bekannt sind Transportsysteme, in welchen die Transportkörper (sogenannte Mover) im elektromagnetischen Feld nahezu reibungsfrei gelagert sind. Die regelbaren elektromagnetischen Kräfte werden sowohl für den Antrieb der Transportkörper als auch für elektromagnetische Linearlagerung oder Levitation über eine flache, elektrisch erregte Transportfläche (auch als X-Y-Stator bezeichnet) benutzt. Ein solches System ist in der WO 2013/059934 A1 beschrieben. Die vorliegende Erfindung baut ausdrücklich auf den darin offenbarten Gegenständen auf. Selbstverständlich ist die erfindungsgemäß vorgeschlagene Sicherung jedoch für sämtliche Planarmotorsysteme mit Transportkörpern mit Permanentmagnet verwendbar. Eine Anforderung in der Nutzung eines solchen Antriebes besteht darin, diesen auch vertikal nutzen zu können. Beispielsweise können die Transportkörper an einer im Wesentlichen vertikalen Wand den Transport von Transportgut ermöglichen. Ebenso ist eine Anordnung über Kopf denkbar. Hierzu muss insbesondere im Falle eines unvorhergesehenen stromlosen Zustandes sichergestellt werden, dass die Transportkörper in ihrer Position verbleiben, was man wohl in Hinblick auf die Arbeitssicherheit als auch die Aufrechterhaltung von Prozesszuständen während einer Unterbrechung einer elektrischen Energieversorgung vorteilhaft ist.

Das Antriebssystem des in der WO 2013/059934 A1 offenbarten Systems verfügt über Permanentmagnete in den Transportkörpern, welche in einer X-Y-Halbach-Anordnung vorgesehen sind. Das Magnetfeld dieser Permanentmagnete interagiert mit dem Magnetfeld elektrischer Leiter im Stator, welche einer an die Magnete abgestimmten spezifischen X-Y-Anordnung folgen. Durch das Zusammenwirken der permanentmagnetischen Halbach-Systeme mit den im Stator durch die Bestromung der Leiterbahnen entstehenden elektromagnetischen Feldern, werden die auf die Transportkörper wirkenden Antriebskräfte in den Richtungen X und Y sowie eine Hebekraft (Tragkraft) in Z-Richtung erzeugt. Eine Herausforderung besteht darin, eine sichere Abbremsung und Positionshaltung der Transportkörper insbesondere im Falle eines Stromausfalls zu gewährleisten. Dies gilt sowohl für den Fall einer waagerechten, als auch einer vertikalen Anordnung von Stator und Transportkörper, insbesondere, wenn die Spannungsversorgung unvermittelt und unerwartet ausfällt. Mitunter verfügen die Transportkörper während der Bewegung noch über relativ große Mengen kinetischer Energie, welche einerseits von der bewegten (Zuleitungs-) Masse und andererseits von der aktuellen Geschwindigkeit im Moment des Stromausfalls abhängt. Durch die Tatsache, dass die Reibung in beiden Richtungen der Bewegungsebene (X/Y-Richtung) sehr klein ist, können die Tragkörper u.U. noch vergleichsweise weite Wege zurücklegen und Schäden an den stationären Antriebselementen, anderen Komponenten des Transportsystems oder sogar an Personen verursachen. Bei den im Stand der Technik bekannten Systemen erfolgt das Abbremsen durch eine Umschaltung der Steuerung auf Bremsbetrieb und stromloses Anhalten beispielsweise folgendermaßen: Bei einem Spannungsausfall der Versorgungsspannung wird die kinetische Energie der Transportkörper in einer Batterie bzw. einem "Supercap" im Zwischenkreis des Antriebssystems rekuperiert bzw. in einem Bremswiderstand vernichtet. Das Abbremsen kann auch durch Verwendung eines Energiepuffers (unterbrechungsfreie Stromversorgung, USV) unterstützt/realisiert werden, so dass ein aktives Bremsen mittels der Antriebskomponenten des Transportsystems möglich ist. Ohne eine USV ist eine Herstellung einer sicheren Konstellation der im Stand der Technik bekannten Systeme jedoch nicht möglich.

Weiter wird auf die EP 2 365 617 A1 verwiesen, welche einen linearen Schrittmotor mit einem Reluktanzelement offenbart.

Es ist eine Aufgabe der vorliegenden Erfindung, die vorgenannten Nachteile zu lindern bzw. auszuräumen.

### Offenbarung der Erfindung

Die vorstehend identifizierte Aufgabe wird erfindungsgemäß durch ein System zur Bewegung permanentmagnet-erregter Transportkörper über ein induktiverregtes Magnetfeld mit den Merkmalen des Anspruchs 1 gelöst. Die Transportkörper können beispielsweise für den Transport von kleinen und leichten Gefäßen oder Gegenständen verwendet werden, wie sie beispielsweise für Arzneimittel (z.B. als Ampullen, als Reagenzglas o.ä.) verwendet werden. Zur Erzeugung des für den Antrieb und die Tragkraft erforderlichen Magnetfeldes ist im Stator ein System von Induktionsspulen vorgesehen, die in der x - bzw. y - Koordinate ausgerichtet sind. Diese können mit einem geregelten elektrischen Signal beaufschlagt werden, um einerseits eine stabile Position, andererseits einen gewünschten Vortrieb in eine vordefinierte Richtung zu erzeugen. Weiter umfasst das erfindungsgemäße System ein verstellbares (im Stator gelagertes) erstes Reluktanzelement und einen Aktuator, wobei letzterer eingerichtet ist, das erste Reluktanzelement von einer ersten Position in eine zweite Position zu bringen. Die beiden Positionen unterscheiden sich bezüglich des Transportkörpers dadurch, dass das Permanentmagnetfeld des über dem ersten Reluktanzelement befindlichen Transportkörpers in der zweiten Position einen geringeren magnetischen Widerstand in einem magnetischen Kreis durch das erste Reluktanzelement erfährt, als in der ersten Position. Mit anderen Worten führt die Position des ersten Reluktanzelementes in der zweiten Position (Sicherungsposition, z.B. im Falle eines Stromausfalls) zu einem geringeren magnetischen Gesamtwiderstand für die Magnetfeldlinien der Permanentmagnete, wobei auch die magnetischen Grenzflächenkräfte aufgrund des erhöhten magnetischen Flusses zunehmen. Einerseits führt dies dazu, dass die Normalkraft auf den Transportkörper zunimmt und im Falle einer vollkommen unbestromten Induktionsspulenanordnung im System die Reibkräfte zwischen dem Transportkörper und einer Oberfläche des Systems zunehmen. Die Reluktanzelemente in der zweiten Position können so ausgerichtet sein, dass in jeweiliger Richtung (Koordinate x, bzw. y) lokale Bereiche entstehen, bei denen der magnetische Widerstand jeweils seinen minimalen Wert erreicht (Rastpositionen). Diese Minima des magnetischen Widerstandes können eine Teilung aufweisen, die einer Hälfte der Polteilung der Halbach-Magnetsysteme in den Transportkörpern entspricht. Andererseits führen die erhöhten Magnetkräfte dazu, dass Magnetkräfte entgegen der Richtung der Bewegung des Transportkörpers in der Ebene erzeugt bzw. verstärkt werden, dank der oben beschriebenen Inhomogenität der Statorreluktanz in der Bewegungsrichtung. Auf diese Weise können die Transportkörper sicher gebremst werden und eine unterbrechungsfreie Stromversorgung zur Durchführung des Bremsvorgangs ist nicht zwingend erforderlich, wenn auch zur Schonung der Oberfläche des Stators eine aktive Bremsung und Landung der Transportkörper erstrebenswert ist. Im Stillstand und auf der Oberfläche gelandet, kann durch ein Sicherungssystem das Entnehmen bzw. Verschieben von Transportkörpern verhindert werden.

Die Unteransprüche zeigen bevorzugte Weiterbildungen der Erfindung.

Bevorzugt ist das System eingerichtet, den magnetischen Widerstand des Systems für ein von einem Transportkörper erregtes Permanentmagnetfeld mittels des ersten Reluktanzelementes an einer Position über dem ersten Reluktanzelement stärker zu verändern, als an einer Position neben dem ersten Reluktanzelement. Mit anderen Worten wird die Inhomogenität der Reluktanz in horizontaler Richtung bzw. in Bewegungsrichtung des Transportkörpers aus der Perspektive des Transportkörpers im Stator erhöht, sobald das erste Reluktanzelement in die zweite Position gebracht wird. Mit anderen Worten wird der magnetische Gesamtwiderstand aus der Perspektive des Transportkörpers verringert und der magnetische Fluss dadurch erhöht, sobald das erste Reluktanzelement in die zweite Position gebracht wird, wodurch die Distanz zwischen dem Reluktanzelement und dem Permanentmagnet-Array verringert wird. Auf diese Weise kann das Permanentmagnetfeld der Transportkörper selbständig und ohne Energiezufuhr (im stromlosen Zustand) für eine sichere Position der Transportkörper im Falle eines Stromausfalls sorgen.

Der Aktuator kann eingerichtet sein, das erste Reluktanzelement gegenüber einem (beispielsweise feststehenden) zweiten Reluktanzelement des Systems in eine veränderte Position zu bringen, um einen magnetischen Gesamtwiderstand durch das erste Reluktanzelement und das zweite Reluktanzelement zu verändern, insbesondere zu verringern. Das erste Reluktanzelement und das zweite Reluktanzelement können hierbei beispielsweise gemeinsam einen magnetischen Kreis für das Permanentmagnetfeld der Transportkörper ausgestalten und sofern das erste Reluktanzelement in der zweiten Position angeordnet ist, dem Magnetfeld einen geringeren magnetischen Widerstand entgegenbringen. Auf diese Weise wird das Magnetfeld durch die magnetischen Kräfte an den Grenzflächen der zweiten Reluktanzelemente verstärkt, welche insbesondere näher am Transportkörper bzw. am Luftspalt des Transportsystems angeordnet sind. Dies erhöht auch die Bremskräfte auf die ansonsten vergleichsweise ungehindert dahingleitenden Transportkörper.

Der Aktuator kann weiter eingerichtet sein, einen Abstand zwischen dem ersten Reluktanzelement und dem zweiten Reluktanzelement zu verändern. Insbesondere kann der Abstand in z-Richtung zu den Transportkörpern ("magnetischer Spalt") in der ersten Position des ersten Reluktanzelementes größer sein als in der zweiten Position des ersten Reluktanzelementes. Einer Erhöhung des Abstandes stellt eine vergleichsweise starke Vergrößerung des magnetischen Widerstandes in Abhängigkeit eines betrachteten Hubes des ersten Reluktanzelements dar.

Eine Möglichkeit, den Aktuator zur Bewegung des ersten Reluktanzelements zu verwenden, besteht darin, dass das erste Reluktanzelement im Wesentlichen parallel zur Ebene der Bewegungsrichtung der Transportkörper und alternativ oder zusätzlich im Wesentlichen senkrecht zur Ebene der Bewegungsrichtung der Transportkörpers zu verschieben. Der Abstand zwischen dem ersten Reluktanzelement und dem Magnet-Array wird allgemein als "Luftspalt" bezeichnet, auch wenn dieser von verschiedenen Materialien mit magnetischen Eigenschaften ähnlich denen von Luft ausgefüllt wird. Die Ebene der Bewegungsrichtung stimmt hierbei im Wesentlichen mit der Erstreckungsrichtung des Luftspaltes zwischen dem Transportkörper und dem erfindungsgemäßen System überein. Alternativ oder zusätzlich kann der Aktuator das erste Reluktanzelement um eine im Wesentlichen parallel zur Bewegungsebene der Transportkörper gelegene Achse rotieren. Beispielsweise kann die Rotation dazu führen, dass in der zweiten Position ein geringerer Abstand zwischen dem Permanentmagneten des Transportkörpers und dem ersten Reluktanzelement besteht.

Bevorzugt kann das erste Reluktanzelement geschichtete Blechelemente aufweisen, welche insbesondere in der ersten Position im Wesentlichen senkrecht zur Ebene der Bewegungsrichtung der Transportkörper orientiert sind. Insbesondere für den Fall, dass das erste Reluktanzelement im Wesentlichen an einer solchen Position eines potentiellen magnetischen Kreises angeordnet sind, in welchem es aufgrund seiner Erstreckungsrichtung eine im Wesentlichen horizontale Komponente des Magnetfeldes leiten soll, ist der magnetische Widerstand des ersten Reluktanzelementes besonders hoch und die Inhomogenität der magnetischen Kräfte gering. Im Ergebnis sind die Bremskräfte gering, weshalb die erste Position auch als "drive mode" bezeichnet wird. Entsprechend kann die Orientierung der geschichteten Blechelemente des ersten Reluktanzelementes in der zweiten Position im Wesentlichen parallel zur Ebene der Bewegungsrichtung der Transportkörper sein. Auch die zweiten Reluktanzelemente können geschichtete Blechelemente aufweisen, wobei diese insbesondere derart orientiert sind, dass die Schichtflächen in einer solchen Ebene liegen, an welcher sie zumindest in der zweiten Position des ersten Reluktanzelementes an das erste Reluktanzelement grenzen. Ein seitliches Austreten von Magnetfeldlinien aus dem zweiten Reluktanzelement wird somit vermieden und eine unerwünschte Verminderung des magnetischen Widerstandes in der ersten Position des ersten Reluktanzelements wird unterbunden.

Das erste Reluktanzelement kann zumindest anteilig zwei pyramidenstumpfförmige Aussparungen aufweisen, welche durch korrespondierende zweite Reluktanzelemente (anteilig) ausgefüllt werden können. Hierbei können die zweiten Reluktanzelemente einen in einer Richtung senkrecht zur Ebene der Bewegungsrichtung der Transportkörper stetig abnehmenden Querschnitt aufweisen. Beispielsweise können die zweiten Reluktanzelemente eine pyramiden- bzw. kegelstumpfförmige Gestalt aufweisen. Beispielsweise kann nun der Aktuator eingerichtet sein, das erste Reluktanzelement senkrecht zur Ebene der Bewegungsrichtung der Transportkörper zu bewegen (also auf- und nieder, bzw. in Z-Richtung). Notwendigerweise ergibt sich nun für die unterschiedliche Position des ersten Reluktanzelementes ein unterschiedlicher Abstand zum zweiten Reluktanzelement bzw. den zweiten Reluktanzelementen. Bevorzugt kann das erste Reluktanzelement eine Oberfläche aufweisen, welche zumindest in der zweiten Position flächig mit einer Oberfläche der zweiten Reluktanzelemente korrespondiert. Mit anderen Worten ist eine möglichst großflächige Grenzfläche zwischen dem ersten und dem zweiten Reluktanzelement vorhanden, wenn sich das erste Reluktanzelement in der zweiten Position befindet. Hierbei ist der Abstand zwischen dem ersten Reluktanzelement und dem zweite Reluktanzelement insbesondere sehr gering zu wählen. Eine solche Konstellation ergibt sich insbesondere dann, wenn die Grenzflächenabschnitte im Wesentlichen parallel sind und sich die Oberfläche des ersten Reluktanzelementes auf diese Weise an die Oberfläche(n) des zweiten Reluktanzelementes bzw. der zweiten Reluktanzelemente anschmiegt.

Um im Falle des Stromausfalls eine Bewegung des ersten Reluktanzelements bewirken zu können, kann der Aktuator ein Energiespeichermittel aufweisen, welches beispielsweise als Feder (mechanische Elastizität) und/oder einen hydraulischen bzw. pneumatischen bzw. elektrischen Energiespeicher umfassen. Je nach den Gegebenheiten der Anlage, in welcher das erfindungsgemäße System betrieben wird, kann die eine oder die andere Energiespeicherform sich als besonders geeignet herausstellen. Ist beispielsweise eine Druckluftversorgung gegeben, können die Druckluftspeicher auch im Falle eines Stromausfalls eine (zeitlich begrenzte) Energieversorgung bereit stellen und somit eine Aktuierung des Systems ermöglichen.

Gemäß einem zweiten Aspekt wird ein Transportsystem vorgeschlagen, welches ein System gemäß dem erstgenannten Erfindungsaspekt und mindestens einem Transportkörper aufweist. Der Transportkörper umfasst einen Tragkörper, auf welchem das Transportgut zu positionieren ist und Permanentmagnete, welche beispielsweise in einer Halbach-Anordnung vorgesehen sein können. Die Permanentmagnete sind entlang des Luftspaltes des Systems angeordnet. Mit anderen Worten folgen die Permanentmagnete im Wesentlichen der Erstreckungsrichtung des Luftspaltes. Sie sind eingerichtet, ein magnetisches Muster zu erzeugen, so dass sich in Verbindung mit dem Reluktanzelement des erfindungsgemäßen Systems eine stark ortsabhängige Kraftwirkung in Richtung der Ebene ergibt, wobei ortsabhängige Unterschiede in der Kraftwirkung durch das erste Reluktanzelement in der zweiten Position erzeugt bzw. verstärkt werden. Auf diese Weise ergibt sich eine entgegen der Bewegungsrichtung wirkende magnetische Bremskraft auf die Transportkörper, sobald die ersten Reluktanzelemente die zweite Position eingenommen haben. Diese resultiert aber hauptsächlich aus der auf dem Transportkörper wirkenden magnetischen Normalkraft, welche durch die Oberflächenreibung zu einer Bremskraft entgegen der Bewegungsrichtung führt. Ein unbeabsichtigtes Verschieben der Transportkörper wird daher erschwert bzw. verhindert.

Ein erfindungsgemäß aufgebautes Transportsystem ist besonders platz- und gewichtssparend realisierbar. Durch die Integration in dem X-Y-Stator kann eine Modularisierung des Statoraufbaus realisiert werden. Die erreichbaren Verzögerungen zwischen einem Stromausfall und einem Bremsvorgang sind deterministisch und möglichst klein. Eine effektive Bremswirkung in einer ersten Brems-Phase kann sogar im System ohne großen elektrischen Speicher bzw. Spannungspufferung erreicht werden. In dieser Phase kann man durch eine entsprechende elektrische Ansteuerung der Leistungselektronik eine Gegenkraft zu der aktuellen Bewegungsrichtung erzeugen. Die dazu notwendige Energie kommt aus der kinetischen Energie des Transportkörpers und wird im generatorischen Betrieb des Antriebs entsprechend umgewandelt. Die durch die Bewegung des Transportkörpers und durch die Wirkung seiner Permanentmagnete bis zum Stillstand entsteht in den Statorwicklungen eine Spannung (sog. Back-EMK) und der Statorstrom kann noch weiter fließen. Durch seine entsprechende Modulation in der Steuerung entsteht eine Bremskraft und unterstützt den Bremsvorgang. Bei der Geschwindigkeit in der Nähe von Null wird die Bremsung stromlos durch das oben beschriebene, variable Reluktanzsystem übernommen.

Zudem sind keine mechanischen Verbindungen zu den Transportkörpern erforderlich. Eine vertikale Installation der Statoren ist möglich, da ein Herabfallen der Transportkörper verhindert wird. Selbstverständlich können mehrere Transportkörper auf einem erfindungsgemäßen System angeordnet werden. Die Transportkörper können unterschiedliche Funktionalitäten ermöglichen. Zudem ist eine direkte Interaktion des Bedieners mit dem System in einer gesicherten Position (die ersten Reluktanzelemente befinden sich in der zweiten Position) möglich. Eine Gefahr von Quetschungen besteht nicht mehr. Die Transportkörper werden im stromlosen Zustand ortsfest und starr mit dem System in Verbindung gehalten. Die Transportkörper können nun nicht mehr oder nur mit einem erheblichen Kraftaufwand entnommen werden. Eine Gefahr von Quetschungen durch Anziehungskräfte zwischen zwei Transportkörpern oder einem Transportkörper und einem magnetisch leitfähigen Material ist gebannt. Die erfindungsgemäß gesicherten Transportkörper können im Magnetfeld nicht verschoben werden. Sie bleiben der Position zum Zeitpunkt des Stromausfalls zugeordnet und können nicht getauscht oder gedreht werden. Auf diese Weise kann eine Störung des Transportvorgangs vermieden und eine relative Zuordnung beibehalten werden. Durch das magnetische Koppeln an einer vordefinierten Position können die Arbeitskräfte erhöht werden. Energetische Optimierungen durch Verlagerung der hohen Belastung in den passiven Status werden möglich.

### Kurze Beschreibung der Zeichnungen

Nachfolgend werden Ausführungsbeispiele der Erfindung unter Bezugnahme auf die begleitenden Zeichnungen im Detail beschrieben. In den Zeichnungen ist:
- Figur 1: eine Seitenansicht zum grundlegenden Aufbau eines Ausführungsbeispiels eines erfindungsgemäßen Transportsystems;
- Figur 2: eine schematische Veranschaulichung eines konkreten Ausführungsbeispiels eines erfindungsgemäßen Transportsystems mit horizontal beweglichen ersten Reluktanzelementen;
- Figur 3: eine Veranschaulichung eines schematischen Aufbaus der Reluktanzelemente in der statischen Reluktanzschicht;
- Figur 4: eine schematische Veranschaulichung einer alternativen Ausführung der ersten Reluktanzelemente in einem Ausführungsbeispiel eines erfindungsgemäßen Transportsystems;
- Figur 5: eine schematische Ansicht eines Ausführungsbeispiels mit verdrehbaren ersten Reluktanzelementen in einer zweiten Position;
- Figur 6: eine schematische Ansicht eines Ausführungsbeispiels mit verdrehbaren ersten Reluktanzelementen in einer ersten Position;
- Figur 7: eine schematische Draufsicht auf ein Ausführungsbeispiel eines erfindungsgemäßen Transportsystems mit drehbaren ersten Reluktanzelementen;
- Figur 8: ein schematisches Ausführungsbeispiel eines erfindungsgemäßen Transportsystems mit einem vertikal verschieblichen profilierten Reluktanzelement in einer zweiten Position;
- Figur 9: ein schematisches Ausführungsbeispiel eines erfindungsgemäßen Transportsystems mit einem vertikal verschieblichen profilierten Reluktanzelement in einer ersten Position;
- Figur 10: eine dreidimensionale Ansicht des in Figur 9 gezeigten Ausführungsbeispiels eines erfindungsgemäßen Transportsystems mit einem erfindungsgemäßen Sicherungssystem;
- Figur 11: eine dreidimensionale Ansicht des in Figur 8 gezeigten Ausführungsbeispiels eines erfindungsgemäßen Transportsystems mit einem erfindungsgemäßen Sicherungssystem;
- Figur 12: eine seitliche Detailansicht eines zweiteiligen Reluktanzsystems mit pyramidenstumpfförmigen ersten Reluktanzelementen mit einem zweiten Reluktanzelement als Joch in einer zweiten Position;
- Figur 13: eine seitliche Detailansicht eines zweiteiligen Reluktanzsystems mit pyramidenstumpfförmigen ersten Reluktanzelementen mit einem zweiten Reluktanzelement als Joch in einer ersten Position;
- Figur 14: ein erstes Ausführungsbeispiel eines per Federkraft angetriebenen Aktuators in einer ersten Position;
- Figur 15: ein erstes Ausführungsbeispiel eines per Federkraft antreibbaren Aktuators in einer zweiten Position;
- Figur 16: eine schematische Seitenansicht eines alternativen Ausführungsbeispiels eines Aktuators mit einem elektromagnetischen Linearantrieb in einer ersten Position;
- Figur 17: eine schematische Seitenansicht eines alternativen Ausführungsbeispiels eines Aktuators mit einem elektromagnetischen Linearantrieb in einer zweiten Position; und
- Figur 18: eine schematische Schaltungsübersicht zur modularen Energieversorgung und Steuerung eines Aktuators.

### Ausführungsformen der Erfindung

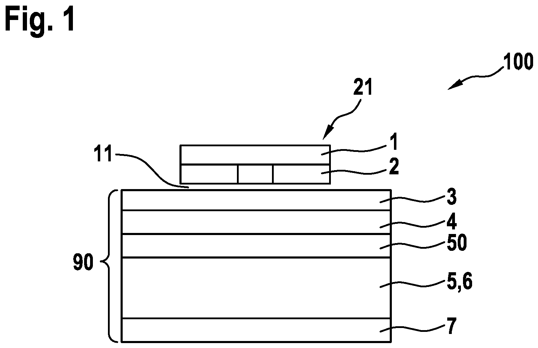

Figur 1 zeigt ein erfindungsgemäßes Transportsystem 100, in welchem ein Transportkörper 21 mittels eines Magnetfeldes über einem erfindungsgemäßen (Stator)-System 90 schwebt. Der Transportkörper 21 weist einen Grundkörper 1 als Tragkörper auf, unterhalb dessen Permanentmagnete 2 angeordnet sind. Unterhalb des Luftspaltes 11 weist das System 90 eine Statorschicht mit Positionssensoren 3 und eine darunterliegende Statorschicht mit einem Wicklungssystem 4 zur Erzeugung der Tragkräfte sowie der Vortriebskräfte auf. Unterhalb des Wicklungssystems 4 ist eine reine Versteifungsebene 50 eingeführt. Diese darf nicht aus einem magnetisch-leitfähigen Material bestehen. Unterhalb der Versteifungsebene 50 ist eine Reluktanzschicht 5,6 angeordnet, in welcher eine statische Reluktanzschicht 5 und eine bewegliche Reluktanzschicht 6 enthalten sind. Hierbei besteht die Option, die bewegliche Reluktanzschicht 6 (bzw. ihre beweglichen Reluktanzelemente) in die Versteifungsebene 50 "einzufahren", damit der Abstand zu den Permanentmagneten 2 des Transportkörpers 21 weiter reduziert und die magentischen Kräfte auf diese Weise erhöht werden können. Mittels der beweglichen Reluktanzschicht 6 kann im Falle eines Stromausfalls erfindungsgemäß die erzeugbare, magnetische Haltekraft beeinflusst werden. Eine unterste Schicht des Systems 90 bildet ein flaches Gehäuse 7 mit einer flächig verteilten Leistungselektronik und Ansteuerungselektronik. Die Leistungs- und Ansteuerungselektronik ist eingerichtet, Positionswerte aus den Signalen der Positionssensoren 3 zur Korrektur der elektrischen Eingangsgrößen für das Wicklungssystem 4 (Regelung der Ströme und somit der Position) zu empfangen und in elektrische Eingangsgrößen für das Wicklungssystem 4 umzuwandeln.

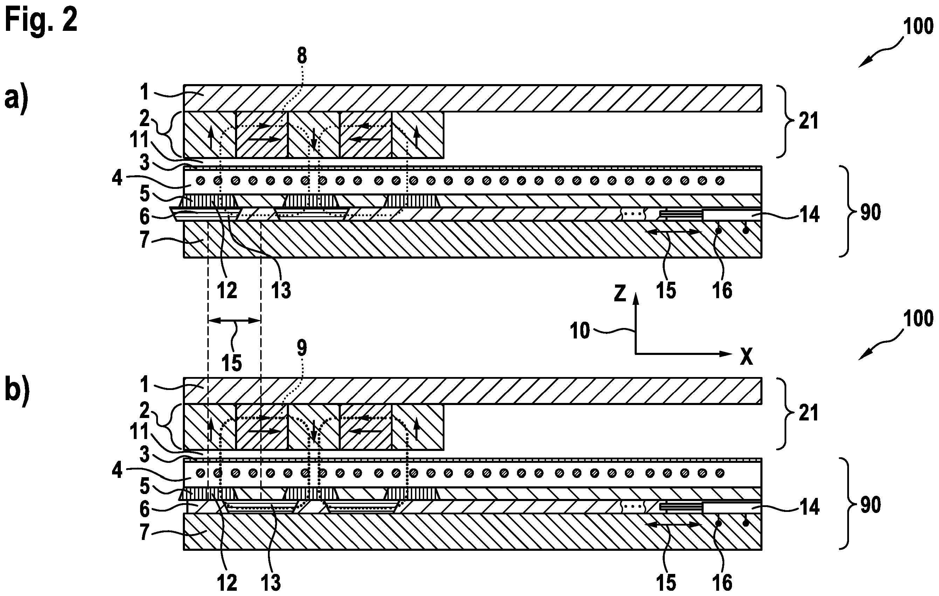

Figur 2 zeigt im oberen Schaubild a) eine mögliche geometrische Anordnung der Permanentmagnetelemente 2 des Transportkörpers 21 sowie eine mögliche Anordnung und Ausgestaltung der Elemente des erfindungsgemäßen Systems 90. Die Permanentmagnete 2 sind abwechselnd in vier unterschiedliche Richtungen (nach oben, nach rechts, nach unten, nach links) orientiert angeordnet. Diese Anordnung entspricht der Halbach-Anordnung, Diese Anordnung dient dazu, dass sich das Gesamtmagnetfeld, welches sich aus den Magnetfeldern der einzelnen Magnetstäbe (oben, rechts, unten links, ...) bildet, hauptsächlich unterhalb des Transportkörpers ausformt. Dies ist nicht nur für den stromlosen Zustand von Bedeutung, sondern auch für den Normalzustand (drive mode). In der dargestellten ersten Position sind die trapezförmigen statischen Reluktanzelemente 12 jedoch im Wesentlichen deckungsgleich mit dem über einen Aktuator 14 verschieblich angeordneten Reluktanzelementen 13 angeordnet. Auf diese Weise sind die nebeneinander angeordneten Reluktanzelementstapel im Wesentlichen magnetisch voneinander isoliert. Über eine vertikale bzw. horizontale Strichelung wird eine Stapelrichtung bzw. Laminierrichtung von Blechelementen der Reluktanzelemente 12, 13 angedeutet. Eine Vorzugsrichtung für eine Führung magnetischen Flusses ergibt sich für die statischen Reluktanzelemente 12 also in vertikaler Richtung, während sie für die verschieblichen Reluktanzelemente 13 in horizontaler Richtung liegt. Entsprechend ist das magnetische Feld 8, welches sich über weite Strecken durch einen zwischen den beweglichen (ersten) Reluktanzelementen 13 befindlichen magnetischen Isolator schließen muss, nicht sehr stark ausgeprägt. Für den Fall, dass die Induktionsspulen des Wicklungssystems 4 aufgrund eines Stromausfalls keinen elektrischen Strom mehr führen und dem Transportkörper 21 keinen vordefinierten Vortrieb mehr bieten können, ergibt sich in der dargestellten Konstellation eine geringe Bremskraft. Zusätzlich dargestellt sind die elektrischen Kontakte 16 zum Gehäuse mit verteilter Leistungselektronik und Ansteuerung für den Aktuator 14. Dessen Hub ist durch einen Doppelpfeil 15 angedeutet. Ein Koordinatensystem 10 zeigt die Position der X- bzw. der Z-Richtung.

Figur 2b) zeigt die in Teilfigur a) dargestellte Konstellation, nachdem der Aktuator 14 im Ansprechen auf eine Unterbrechung eines Versorgungsstroms angesprochen und die verschiebliche Reluktanzschicht 6 in eine solche Position verschoben hat, dass die verschieblichen ersten Reluktanzelemente 13 eine Brücke zwischen den statischen Reluktanzelementen 12 schlagen. Entsprechend ist das sich einstellende Permanentmagnetfeld 9 wesentlich stärker, da die magnetischen Luftspalte zwischen den Reluktanzelementen 12 durch die Verschiebung der unteren Reluktanzschicht 6 eliminiert wurden (die Linien wurden entsprechend 9 kräftiger dargestellt). Die inhomogene Reluktanz des Systems 90 führt zu einer Vorzugsstellung der Transportkörper 21, und zwar so, dass die vertikal orientierten Permanentmagnete 2 über den statischen Reluktanzelementen 12 des Systems 90 zum Stehen kommen.

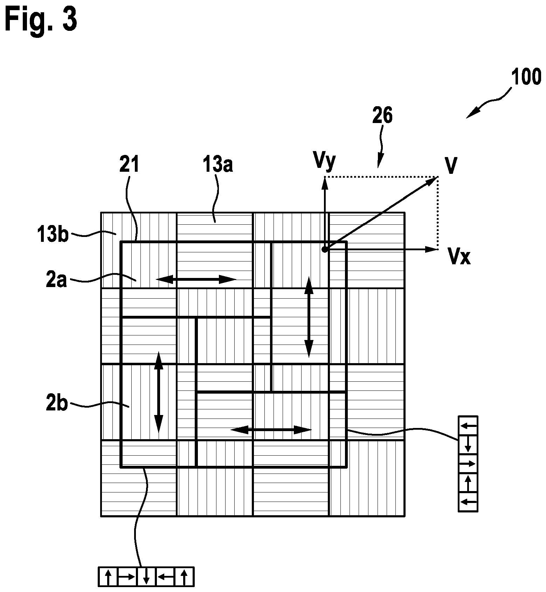

Figur 3 zeigt das Ausführungsbeispiel aus Figur 2 in einer schematischen Draufsicht. Hierbei wird der dreidimensionale Charakter durch die Zusammenschau der Figuren 2 und 3 erkennbar. Mit 2a bzw. 2b sind die Halbach-Permanentmagnete des Transportkörpers 21 bezeichnet, wobei die Magnete 2a in X-Richtung und die Magnete 2b in Y-Richtung ausgerichtet sind. Mit 13a bzw. 13b sind die steuerbaren ersten Reluktanzelemente bezeichnet, wobei 13a die in X-Richtung und 13b die in Y-Richtung orientierten Reluktanzelemente bezeichnet. Das Koordinatensystem 26 kennzeichnet die Geschwindigkeitskomponenten des Transportkörpers 21 in der Erstreckungsrichtung des Luftspaltes (entsprechend der Zeichnungsebene). Die Fläche des Transportkörpers 21 entspricht einer Vielzahl steuerbarer erster Reluktanzelemente 13a, 13b (s. auch Figur 2). In der dargestellten Ausführung entspricht die Fläche exakt neun ersten Reluktanzelementen 13a, 13b mit einer sich schachbrettartig wechselnden Ausrichtung (in X- bzw. in Y-Richtung).

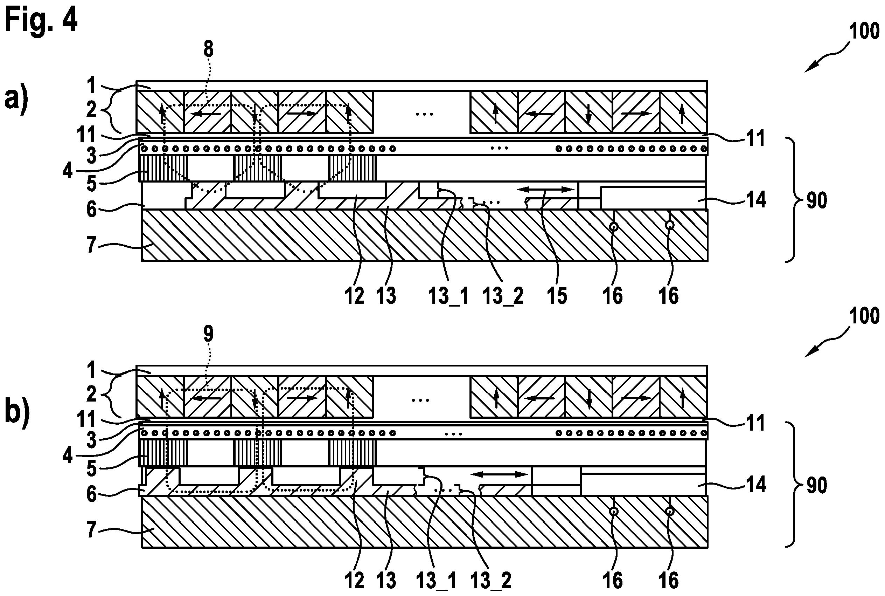

Figur 4 zeigt eine Variation des in Figur 2 veranschaulichten Ausführungsbeispiels, wobei Teilfigur a) die verschiebliche Reluktanzschicht 6 in einem "drive mode" (Normalposition) und die Teilfigur b) die erste Reluktanzschicht 6 im "safety mode" (Sicherungsposition) zeigt. Im Unterschied zu den ersten Reluktanzelementen 13 in Figur 2 sind die Flanken der in Figur 4 gezeigten ersten Reluktanzelemente 13 im Wesentlichen vertikal gehalten. Die erste Reluktanzschicht 6 weist hier ein einstückig ausgeführtes erstes Reluktanzelement 13 auf, welches mit den statischen (zweiten) Reluktanzelementen 12 korrespondierende Strukturen 13_1 aufweist, welche über ein im Wesentlichen horizontal erstrecktes Jochband 13_2 miteinander verbunden sind. Analog zu der in Verbindung mit Figur 2 dargestellten

Ausführungsform, welche eine lineare Verschiebung der Reluktanzelemente 13 offenbart, kann über eine rotatorische Verschiebung um die Z-Achse ein vergleichbarer Effekt erzielt werden.

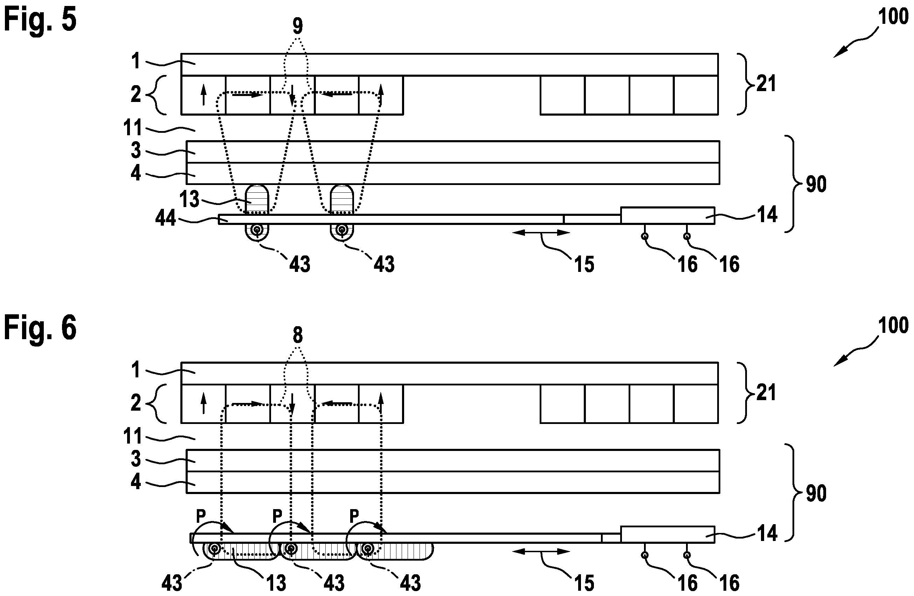

Figur 5 zeigt ein Ausführungsbeispiel, bei welchem die ersten Reluktanzelemente 13 an einer jeweiligen horizontalen Achse 43 rotationsfähig angebracht sind. Bezüglich der Achse 43 sind die ersten Reluktanzelemente 13 exzentrisch aufgehängt. Eine Zahnstange 44 korrespondiert mit im Bereich der Achsen 43 angeordneten Zahnrädern, so dass ein Aktuator 14 über die Zahnstange 44 durch Bewegung entlang eines Doppelpfeils 15 dafür sorgen kann, dass in der in Figur 5 dargestellten zweiten Position der ersten Reluktanzelemente 13 ein Abstand zwischen den ersten Reluktanzelementen 13 und dem Transportkörper 21 minimal ist und die Blechelemente in vertikaler Richtung übereinander gestapelt sind. Auf diese Weise ergibt sich ein minimaler magnetischer Widerstand für die Magnetfeldlinien 9, welche sich aufgrund der Permanentmagnete 2 des Transportkörpers 21 ausbilden. Die übrigen Elemente entsprechen im Wesentlichen denen der in Verbindung mit den Figuren 2 und 4 gezeigten Ausführungsbeispiele.

Figur 6 zeigt die in Figur 5 dargestellte Ausführungsform, nachdem der Aktuator 14 eine Wiederherstellung der elektrischen Energieversorgung erkannt hat. Über die Zahnstange 44 und die Zahnräder 43 führt der Aktuator 14 einen solchen Hub in Richtung des Pfeils 45 aus, dass sich die ersten Reluktanzelemente 13 in Richtung jeweiliger Pfeile P um 90° nach rechts verdrehen. Einerseits vergrößert sich auf diese Weise der Abstand zwischen den Permanentmagneten 2 des Transportkörpers 21 und den ersten Reluktanzelementen 13, andererseits sind die Blechelemente der ersten Reluktanzelemente 13 nun gegenüber der Hauptrichtung der Magnetfeldlinien 8 um 90° gedreht und realisieren somit einen besonders hohen magnetischen Widerstand. Die Anordnung nach Fig. 5, und Fig. 6 hat zum Vorteil, dass die Lagerung wie auch der Antrieb vereinfacht realisiert werden können.

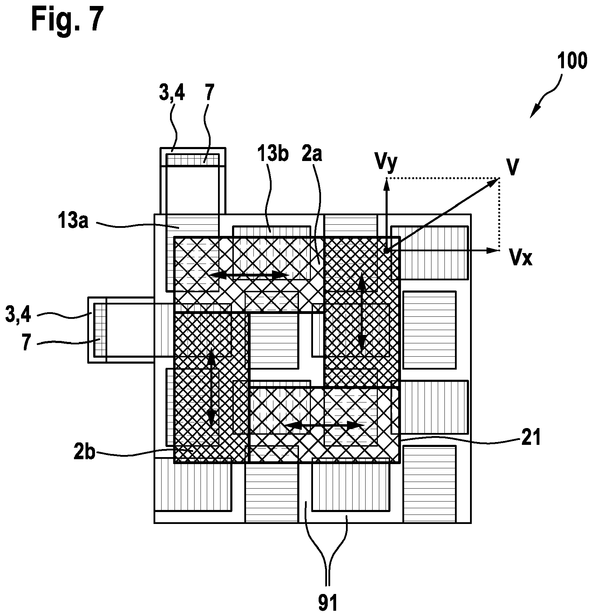

Figur 7 zeigt eine Draufsicht auf das in den Figuren 5 und 6 gezeigte Ausführungsbeispiel mit steuerbaren (z.B. drehbaren) ersten Reluktanzelementen 13a, 13b. Die Anordnung der Komponenten des Stators, des Transportkörpers 21 und der Reluktanzelemente 13a, 13b ist segmentweise in der Leistungselektronik- und Ansteuerungsgehäuseschicht 7 unterhalb der Reluktanzelementschichten 5, 6 eingebettet. Schmale Verbindungsbereiche 91 säumen die Kanten der steuerbaren Reluktanzelemente 13a, 13b und sorgen für eine Verbindung mit der Gehäuseschicht 7 und Durchführung der elektrischen Verbindungen zu dem Wicklungssystems des Stators.

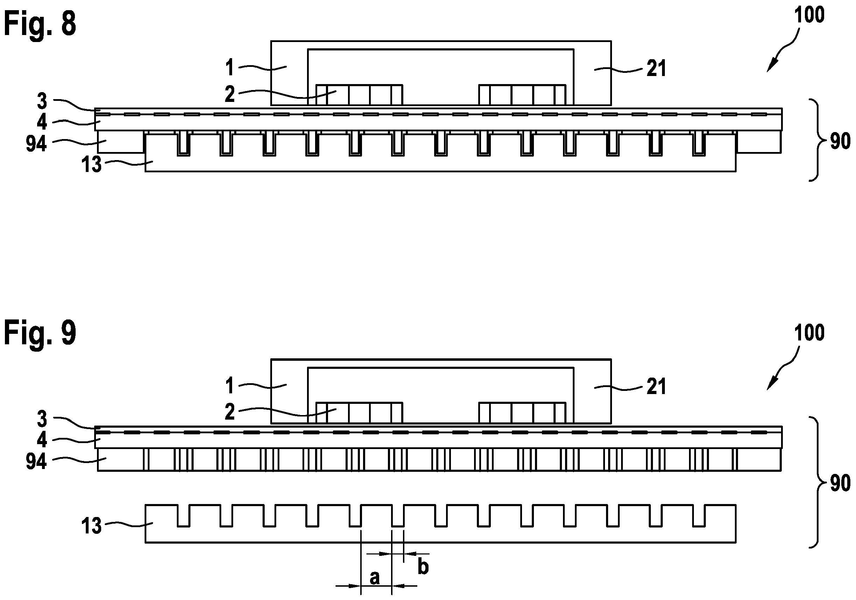

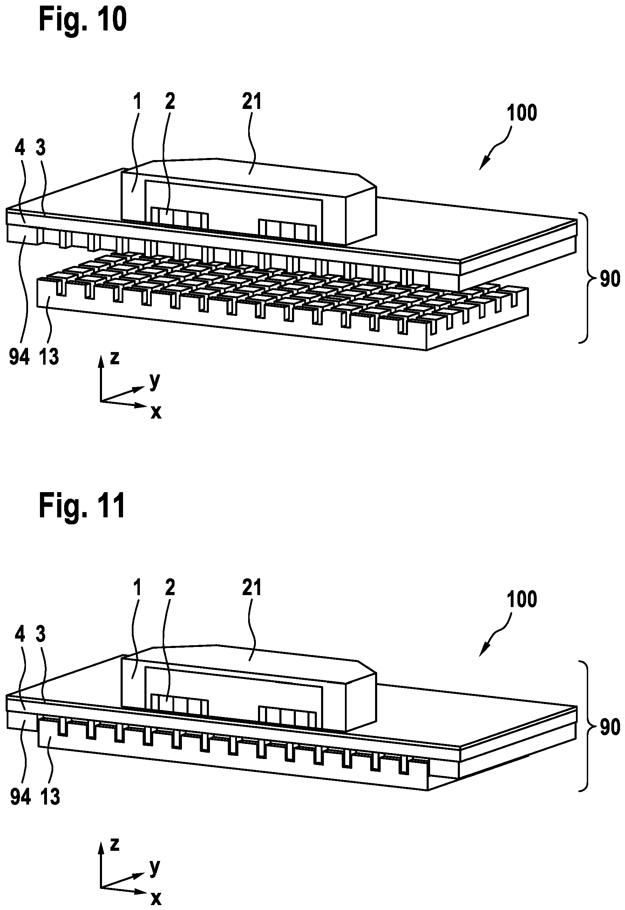

Figur 8 zeigt eine Seitenansicht eines alternativen Ausführungsbeispiels eines erfindungsgemäßen Transportsystems 100, bei welchem ein profiliertes erstes Reluktanzelement 13 in Z-Richtung (vertikal) verschoben werden kann, um es aus einer ersten Position in eine zweite Position zu bringen. Figur 8 stellt die zweite Position dar, in welcher das kammförmig profilierte erste Reluktanzelement 13 in Eingriff mit einer korrespondierend ausgestalteten Versteifungsebene 94 steht. Auf diese Weise ist ein Abstand zu dem Permanentmagneten 2 des Transportkörpers 21 minimal und der Transportkörper 21 wird magnetisch gebremst. Die Bremswirkung ergibt sich zum größten Teil aus den Anziehungskräften der Magnete gegenüber dem magnetischen Rückschluss über die Reluktanzelemente des Systems 90, welche die Ausbildung von Reibkräften (Bewegung) und Haftkräften (Stillstand) zur Folge haben. Durch die profilierte Form des ersten Reluktanzelementes 13 kann jedoch zudem eine mehr oder minder stark ausgeprägte Rastung erzielt werden, wodurch auch eine magnetische Bremskraft in Richtung der x- bzw. y-Richtung erzeugt wird. Die Struktur des ersten Reluktanzelements 13 kann in X- und Y-Richtung identisch ausgeformt sein, wie dies in den nachfolgend diskutierten Figuren 10 und 11 dargestellt ist. Somit lässt sich ein einziges Reluktanzelement 13 gestalten, welches die unterschiedlich ausgerichteten Halbach-Array-Magnete 2 gleichermaßen bedient und eine richtungsunabhängige Sicherung der Transportkörper 21 ermöglicht. Der Abstand zwischen den Halbach-Magneten 2 und dem ersten Reluktanzelement 13 kann durch eine Abstimmung des mechanischen Aufbaues der Versteifungsebene 94 und dem ersten Reluktanzelement 13 verringert werden, wodurch höhere Haltekräfte erzielt werden können. Die Versteifungsebene 94 besteht aus einem diamagnetischen oder paramagnetischen Material. Das erste Reluktanzelement 13 kann sich aus einem einzelnen oder aus einer Kombination ferromagnetischer Werkstoffe zusammensetzen. Hierzu zählen auch Elektrobleche (Blechelemente). Für die benötigte Verschiebung von der Position 1 in diese Position eignen sich gängige Aktuatoren, beispielsweise pneumatische Zylinder. Bedingt durch den nichtlinearen Anstieg der Anzugskraft in z-Richtung bei Verringerung des Luftspaltes ist über eine geeignete Kinematik eine Kompensation auf Aktorseite erreichbar, beispielhaft sei ein Kniehebel genannt.

Figur 9 zeigt das in Figur 8 eingeführte Ausführungsbeispiel in einer ersten Position ("drive mode"), bei welchem das Reluktanzelement 13 um einen vordefinierten Abstand von den Magneten 2 des Transportkörpers 21 entfernt ist. Dieser Abstand ist so gewählt, dass die Interaktion der Magnetfelder der Magnete 2 mit dem Reluktanzelement 13 vernachlässigbar wird. Das Verhältnis a durch b der Breiten der unterschiedlich hohen Reluktanzelementabschnitte wirkt sich direkt auf die Ausprägung der Halte- und Rastkraft aus. Gilt a » b, wird die Haltekraft maximal und die Rastkraft minimal. Gilt hingegen a « b, wird die Haltekraft minimal und die Rastkraft maximal. Die Haltekraft wird aufgrund des Mindestabstands zwischen dem ersten Reluktanzelement 13 und dem Magneten 2 des Transportkörpers 21, welcher der Gesamthöhe der Sensorschicht 3 und der Spulenschicht 4 entspricht, in der Regel über die Rastkraft dominiert.

Die Figuren 10 und 11 zeigen das in den Figuren 8 und 9 gezeigte und vorstehend beschriebene Ausführungsbeispiel in einer isometrischen Ansicht. Hierbei wird ersichtlich, dass die Maße a, b sowohl in X- als auch in Y-Richtung die Struktur des ersten Reluktanzelements 13 beschreiben.

Das Reluktanzelement 13 kann aus einem einzelnen oder einem Verbund mechanischer Komponenten bestehen. Diese Elemente können relativ zueinander und voneinander unabhängig in Z-Richtung (also in Richtung der Transportkörper 21) verschoben werden, um beispielsweise die zum Lösen des "safety modes" (zweite Position) benötigte, mittlere Kraft zu reduzieren und gegebenenfalls auf mehrere Aktoren aufzuteilen.

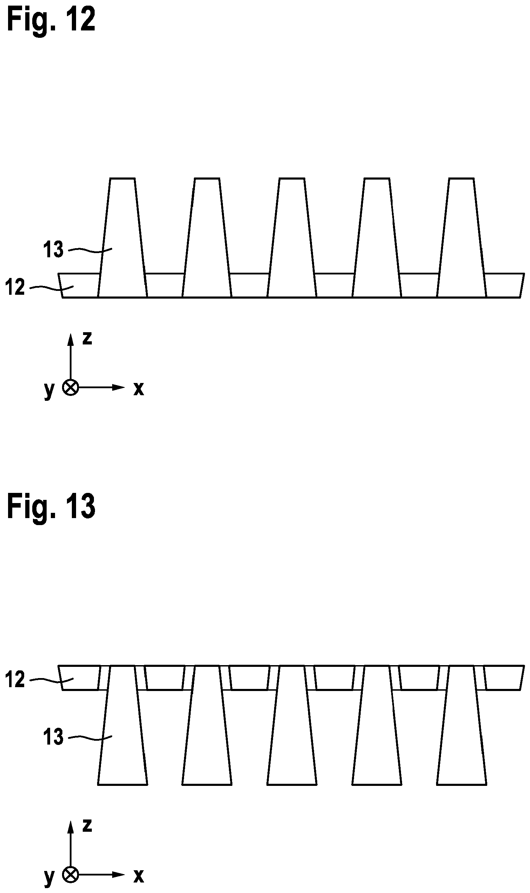

Die Figuren 12 und 13 zeigen ein Ausführungsbeispiel mit einem zweigeteilten Reluktanzelement. Hierbei besteht das erste Reluktanzelement 13 aus einer sich wiederholenden pyramidenstumpfförmigen Struktur. Diese ist in einem für den safety mode relevanten Mindestabstand gegenüber den Magneten des Transportkörpers angebracht. Die pyramidenstumpfförmigen ersten Reluktanzelemente 13 werden durch ein statisches, bezüglich seiner Oberflächen an die Flanken des ersten Reluktanzelementes 13 angepasstes Joch 12 als zweites Reluktanzelement umgeben. Es besteht aus einer ortsfesten Komponente, die in für den safety mode relevanten Mindestabstand gegenüber den Permanentmagneten des Transportkörpers angebracht ist. Die pyramidenstumpfförmigen ersten Reluktanzelemente 13 werden entsprechend der Figur 12 in Richtung der Transportkörper maximal in das Joch 12 eingeschoben, um einerseits deren Abstand von dem Transportkörper, andererseits ihren Abstand zum Joch 12 zu minimieren. In Figur 13 wurden die pyramidenstumpfförmigen ersten Reluktanzelemente 13 in negative Z-Richtung verschoben, um deren Abstand zum Transportkörper sowie zum Joch 12 zu maximieren. Eine Kombination dieses Konzepts mit den Figuren 2 und 4 beschriebenen, horizontalen Verschiebungen des ersten Reluktanzelementes 13 ist selbstverständlich ebenfalls im Rahmen der vorliegenden Erfindung denkbar.

Um die Aktivierung des safety modes im Falle einer fehlenden Leistungsversorgung ausführen zu können, müssen passive Aktuatoren ein gewisses Maß an Energie speichern. Beispielsweise können mechanische Federn für den Übergang vom drive mode zum safety mode verwendet werden.

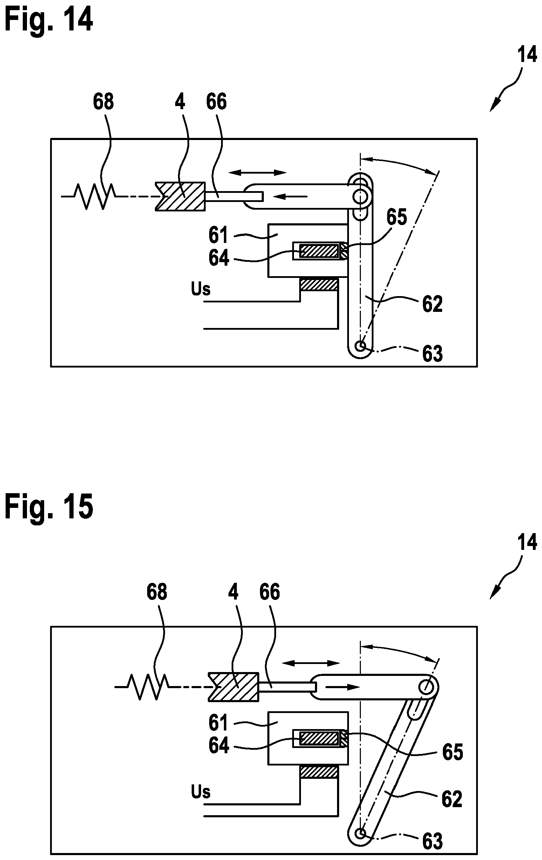

Figur 14 zeigt ein erstes Ausführungsbeispiel eines Kniehebel-Aktuators 14, welcher zwei stabile Zustände aufweist. Ein unten über eine Achse 63 gelagerter Hebel 62 wird in der dargestellten Position durch zwei Permanentmagnete 65 und eine Spule 64 entgegen der Druckkraft einer Feder 68 gehalten. Die Feder 68 drückt über die erste Reluktanzschicht 4 und einen Kolben 66 auf einen im Wesentlichen horizontal erstreckten Teil des Kniehebels, welcher in einer Langlochkulisse eines vertikalen Hebels 62 gelagert ist. Die Spule 64 ist in einem Aktor Stator 61 gelagert, welcher beispielsweise aus geschichteten Blechen bestehen kann. Sofern eine Versorgungsspannung Us abgeschaltet wird, verschwindet die über die Spule 64 erzeugte Haltekraft auf den Hebel 62 und die Feder 68 überwindet die verbleibende, durch die Permanentmagnete 65 ausgeübte Haltekraft.

Figur 15 stellt das Resultat einer Abschaltung der Versorgungsspannung Us dar. Die Feder 68 hat über den Kolben 66 den Kniehebel gekippt, wodurch sich die erste Reluktanzschicht 4 in einen safety mode (zweite Position) begeben hat. Die in den Figuren 14 und 15 dargestellten Zustände sind stromlos stabil, wodurch keine zusätzlichen Verluste beim Halten (safety mode) oder beim Fahren (drive mode) in Kauf genommen werden müssen. Die Spannung Us ist reversierbar.

Damit kann durch eine Spannung (z.B. einen Stromimpuls), welche an die Spule 64 angelegt wird, die Position bi-stabil gewechselt werden.

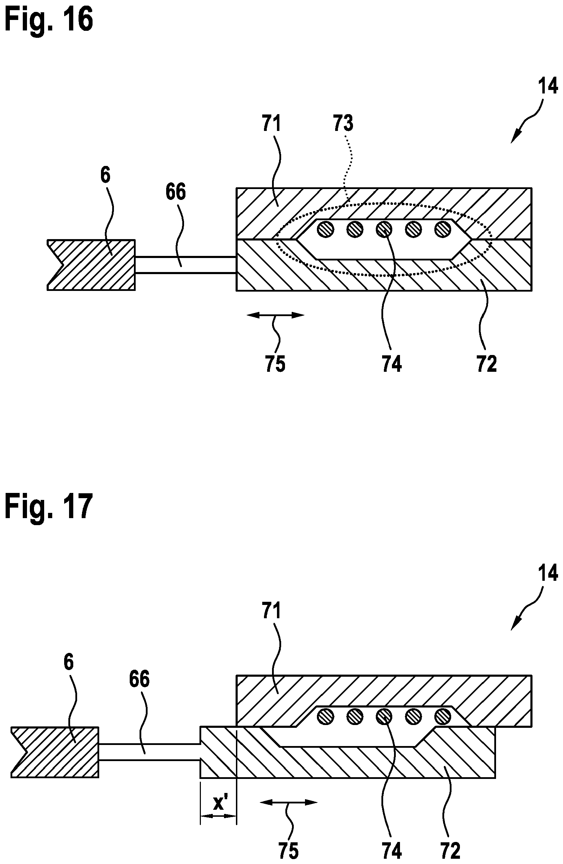

Figur 16 zeigt ein alternatives Ausführungsbeispiel für einen Aktuator 14, welcher über eine elektromagnetische lineare Spulenanordnung eine besonders flache Bauform ermöglicht. Werden die Windungen 74 vom Versorgungsstrom (oder einem anderen, aus dem Versorgungsstrom abgeleiteten Strom) durchflossen, ergibt sich ein Magnetfeld 73, welches sich über die korrespondierenden Flächen der Eisenkerne 71, 72 schließt. Die untere Hälfte des Eisenkerns 72 ist über einen Kolben 76 mit der beweglichen Reluktanzschicht 6 gekoppelt. Zudem ist eine (nicht dargestellte) Feder dafür vorgesehen, die bewegliche Reluktanzschicht 6 nach links vorzuspannen. Die lineare Bewegungsrichtung des dargestellten Aktuators 14 ist durch einen Doppelpfeil 75 angezeigt.

Figur 17 zeigt die Situation des in Figur 16 dargestellten Ausführungsbeispiels für einen Aktuator 14 nach einem Abschalten der Versorgungsspannung. Die nachlassenden magnetischen Kräfte führen dazu, dass die (nicht dargestellte) Feder die bewegliche Reluktanzschicht 6 in die zweite Position verschiebt. Der Hub der ersten Reluktanzschicht 6 ist mit x* gekennzeichnet. Der dargestellte lineare Aktuator 14 ermöglicht eine in beide Richtungen X und Y einstellbare Brems- und Haltekraft. Entsprechend können Versionen der dargestellten Anordnung für "pneumatisch bi-stabile" und "pneumatisch lineare" Aktuatoren durch Analogie zu den elektrischen Ansteuerungen gemäß den Figuren 14 bis 17 mit pneumatischen Energiequellen realisiert werden.

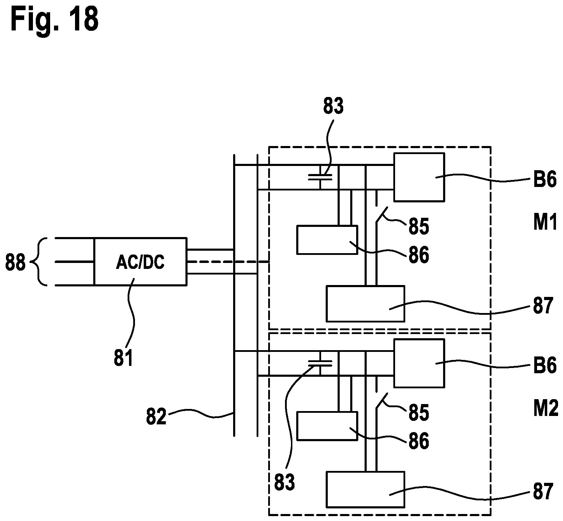

Figur 18 zeigt eine schematische Schaltung zur Versorgung und Steuerung der Aktuatoren gemäß den oben beschriebenen Systemen 90 bzw. den Transportsystemen 100. Die Schaltung stellt eine modulare Energieversorgung und Ansteuerung der Aktuatoren dar. Gespeist wird die Schaltung durch ein DreiPhasen-System 88, dessen Spannung (z.B. 3x380V) über einen AC/DC-Wandler 81 auf eine zentrale Zwischenkreisspannung in einer Stromschiene 82 gewandelt wird. Beispielhaft sind zwei Module M1, M2 dargestellt, welche in beliebiger Anzahl entsprechend den mechanischen Gegebenheiten einer tatsächlichen Realisierung ergänzt werden können. Bezugszeichen 83 kennzeichnet einen lokalen Spannungspuffer in Form eines Zwischenkreiskondensators, welcher parallel zu einem elektrischen Energiespeicher 86 liegt. Der elektrische Energiespeicher 86 kann beispielsweise in Form eines Kondensators, eines super caps, eines Akkumulators o.ä. zum motorischen Bremsen im Falle einer Spannungsunterbrechung realisiert werden. Über einen Schalter 85 wird eine modulspezifische Ansteuerschaltung 87 für den Antrieb inklusive einer hat-Position hinzugeschaltet. Eine B6-Brücke ist für die Ansteuerung der Linearmotoren bzw. der Induktionsspulen 4 (aufgeteilt für eine Antriebskraft in Richtung der x- bzw. y-Koordinate) vorgesehen. Der Aufbau einer B6-Brücke ist in der Literatur hinreichend bekannt und wird hier nicht weiter diskutiert.

Die vorgestellten Systeme bzw. Transportsysteme gemäß der vorliegenden Erfindung können beispielsweise für Pharma-Anwendungen oder in der Produktions- und Montagetechnik eingesetzt werden, ohne dass die Anwendungsfälle der vorliegenden Erfindung auf die vorgenannten Bereiche beschränkt sind.

## Patentansprüche

1. System (90) zur Bewegung permanentmagneterregter Transportkörper (21) über ein induktiv erregtes Magnetfeld umfassend Induktionsspulen (4), die eingerichtet sind, von einem Strom durchflossen zu werden, um die Transportkörper (21) berührungslos zu levitieren und in einer Ebene anzutreiben,
**dadurch gekennzeichnet, dass** ein beweglich gelagertes erstes Reluktanzelement (13) und ein Aktuator (14) vorgesehen sind, wobei der Aktuator (14) eingerichtet ist, das erste Reluktanzelement (13) von einer ersten Position in eine zweite Position zu bringen, wobei ein Permanentmagnetfeld (8, 9) eines über dem ersten Reluktanzelement (13) befindlichen Transportkörpers (21) in der zweiten Position einen geringeren magnetischen Widerstand in einem magnetischen Kreis durch das erste Reluktanzelement (13) erfährt als in der ersten Position.

2. System nach Anspruch 1, wobei der Aktuator (14) eingerichtet ist, das erste Reluktanzelement (13) im Falle eines Stromausfalls aus der ersten in die zweite Position zu bringen, um seine Bewegung (V) in der Ebene zu bremsen.

3. System nach Anspruch 1 oder 2, wobei das System (90) eingerichtet ist, den magnetischen Widerstand des Systems für ein von einem Transportkörper (21) erregtes Permanentmagnetfeld (8, 9) mittels des ersten Reluktanzelementes (13) an einer Position über dem ersten Reluktanzelement (13) stärker zu verändern als an einer bezüglich der Bewegung der Transportkörper (21) benachbarten Position.

4. System nach einem der vorstehenden Ansprüche, wobei der Aktuator (14) eingerichtet ist, das erste Reluktanzelement (13) gegenüber einem, insbesondere feststehenden, zweiten Reluktanzelement (12) des Systems in eine andere Position zu bringen, um einen magnetischen Widerstand durch das erste Reluktanzelement (13) und das zweite Reluktanzelement (12) zu verändern.

5. System nach Anspruch 4, wobei der Aktuator (14) eingerichtet ist, einen Abstand zwischen dem ersten Reluktanzelement (13) und dem zweiten Reluktanzelement (12) zu verändern.

6. System nach einem der vorstehenden Ansprüche, wobei der Aktuator (14) eingerichtet ist, das erste Reluktanzelement (13)
- im Wesentlichen parallel zur Ebene der Bewegungsrichtung der Transportkörper (21), und/oder
- im Wesentlichen senkrecht zur Ebene der Bewegungsrichtung der Transportkörper (21) zu verschieben, und/oder
- um eine im Wesentlichen in der Ebene der Bewegungsrichtung der Transportkörper (21) gelegene Achse (43) zu rotieren.

7. System nach einem der vorstehenden Ansprüche, wobei das erste Reluktanzelement (13) geschichtete Blechelemente aufweist, welche insbesondere
- in der ersten Position im Wesentlichen senkrecht zur Ebene der Bewegungsrichtung der Transportkörper (21) und
- in der zweiten Position im Wesentlichen parallel zur Ebene der Bewegungsrichtung der Transportkörper (21) orientiert sind.

8. System nach einem der vorstehenden Ansprüche, wobei das erste Reluktanzelement (13) zumindest anteilig zwischen zwei zweiten Reluktanzelementen (12) angeordnet ist, wobei
- die zweiten Reluktanzelemente (12) einen in einer Richtung senkrecht zur Ebene der Bewegungsrichtung der Transportkörper (21) stetig abnehmenden Querschnitt aufweisen, wobei insbesondere
- der Aktuator (14) eingerichtet ist, das erste Reluktanzelement (13) senkrecht zur Ebene der Bewegungsrichtung der Transportkörper (21) zu bewegen, und/oder
- das erste Reluktanzelement (13) eine Oberfläche aufweist, welche zumindest in der zweiten Position flächig mit einer Oberfläche der zweiten Reluktanzelemente (12) korrespondiert.

9. System nach einem der vorstehenden Ansprüche, wobei der Aktuator (14) ein Energiespeichermittel, insbesondere
- eine Feder (68), und/oder
- einen hydraulischen und/oder
- pneumatischen und/oder
- elektrischen Energiespeicher
umfasst.

10. Transportsystem (100), umfassend
- ein System (90) nach einem der vorstehenden Ansprüche, und/oder
- einen Transportkörper (21) umfassend
- einen Tragkörper (1) und
- Permanentmagnete (2), wobei
die Permanentmagnete (2) im Wesentlichen entlang einer Ebene einer Bewegungsrichtung des Transportkörpers (21) über dem System (90) angeordnet sind und ein magnetisches Muster erzeugen, so dass sich in Verbindung mit den Reluktanzelementen (12, 13) des Systems (90) eine stark ortsabhängige Kraftwirkung in Richtung der Ebene ergibt, wobei ortsabhängige Unterschiede in der Kraftwirkung durch das erste Reluktanzelement (13) in der zweiten Position verstärkt werden.

## Claims

1. System (90) for moving transport bodies (21) excited by permanent magnets over an inductively excited magnetic field, comprising induction coils (4) which are designed to be flowed through by a current, in order to levitate the transport bodies (21) contactlessly and drive them in a plane,
**characterized in that** a movably supported first reluctance element (13) and an actuator (14) are provided, wherein the actuator (14) is designed to bring the first reluctance element (13) from a first position into a second position, wherein a permanent magnetic field (8, 9) of a transport body (21) located over the first reluctance element (13) experiences a smaller magnetic resistance in a magnetic circuit as a result of the first reluctance element (13) in the second position than in the first position.

2. System according to Claim 1, wherein the actuator (14) is designed to bring the first reluctance element (13) out of the first position into the second position in the event of a power failure in order to brake its movement (V) in the plane.

3. System according to Claim 1 or 2, wherein the system (90) is designed to change the magnetic resistance of the system for a permanent magnetic field (8, 9) excited by a transport body (21) by means of the first reluctance element (13) to a greater degree at a position over the first reluctance element (13) than at a position alongside the first reluctance element with respect to the movement of the transport bodies (21).

4. System according to one of the preceding claims, wherein the actuator (14) is designed to bring the first reluctance element (13) into a different position with respect to a, in particular fixed, second reluctance element (12) of the system in order to change a magnetic resistance through the first reluctance element (13) and the second reluctance element (12).

5. System according to Claim 4, wherein the actuator (14) is designed to change a distance between the first reluctance element (13) and the second reluctance element (12).

6. System according to one of the preceding claims, wherein the actuator (14) is designed to displace the first reluctance element (13)
- substantially parallel to the plane of the direction of movement of the transport bodies (21), and/or
- substantially perpendicular to the plane of the direction of movement of the transport bodies (21), and/or
- to rotate the first reluctance element (13) about an axis (43) situated substantially in the plane of the direction of movement of the transport bodies (21).

7. System according to one of the preceding claims, wherein the first reluctance element (13) comprises laminated sheet-metal elements, which are in particular
- in the first position oriented substantially perpendicular to the plane of the direction of movement of the transport bodies (21) and
- in the second position oriented substantially parallel to the plane of the direction of movement of the transport bodies (21).

8. System according to one of the preceding claims, wherein the first reluctance element (13) is at least partially arranged between two second reluctance elements (12), wherein
- the second reluctance elements (12) have a cross section that continuously decreases in a direction perpendicular to the plane of the direction of movement of the transport bodies (21), wherein in particular
- the actuator (14) is designed to move the first reluctance element (13) perpendicularly in relation to the plane of the direction of movement of the transport bodies (21), and/or
- the first reluctance element (13) has a surface that corresponds over the surface area to a surface of the second reluctance elements (12), at least in the second position.

9. System according to one of the preceding claims, wherein the actuator (14) comprises an energy storage means, in particular
- a spring (68), and/or
- a hydraulic and/or
- pneumatic and/or
- electrical energy store.

10. Transport system (100), comprising
- a system (90) according to one of the preceding claims, and/or
- a transport body (21) comprising
- a carrying body (1) and
- permanent magnets (2), wherein
the permanent magnets (2) are arranged over the system (90) substantially along a plane of a direction of movement of the transport body (21) and produce a magnetic pattern, so that, together with the reluctance elements (12, 13) of the system (90), a strongly location-dependent force effect is obtained in the direction of the plane, wherein location-dependent differences in the force effect are intensified by the first reluctance element (13) in the second position.

## Revendications

1. Système (90) de déplacement d'éléments de transport (21) excités par des aimants permanents par le biais d'un champ magnétique excité par induction, comportant des bobines d'inductance (4) qui sont conçues pour être traversées par un courant, afin de faire léviter les éléments de transport (21) sans contact et de les entraîner dans un plan,
**caractérisé en ce qu'**un premier élément à réluctance (13) monté mobile et un actionneur (14) sont prévus, l'actionneur (14) étant conçu pour amener le premier élément à réluctance (13) d'une première position à une deuxième position, un champ magnétique permanent (8, 9) d'un élément de transport (21) situé au-dessus du premier élément à réluctance (13) subissant une résistance magnétique dans un circuit magnétique par le biais du premier élément à réluctance (13), laquelle résistance magnétique est plus faible dans la deuxième position que dans la première position.

2. Système selon la revendication 1, dans lequel l'actionneur (14) est conçu pour amener le premier élément à réluctance (13) de la première à la deuxième position en cas de panne de courant, afin de freiner son déplacement (V) dans le plan.

3. Système selon la revendication 1 ou 2, le système (90) étant conçu pour modifier la résistance magnétique du système pour un champ magnétique permanent (8, 9) excité par un élément de transport (21) au moyen du premier élément à réluctance (13) plus fortement à une position au-dessus du premier élément à réluctance (13) qu'à une position adjacente par rapport au déplacement des éléments de transport (21).

4. Système selon l'une des revendications précédentes, dans lequel l'actionneur (14) est conçu pour amener le premier élément à réluctance (13) dans une autre position par rapport à un deuxième élément à réluctance (12), en particulier fixe, du système, afin de modifier une résistance magnétique par le biais du premier élément à réluctance (13) et du deuxième élément à réluctance (12).

5. Système selon la revendication 4, dans lequel l'actionneur (14) est conçu pour modifier une distance entre le premier élément à réluctance (13) et le deuxième élément à réluctance (12).

6. Système selon l'une des revendications précédentes, dans lequel l'actionneur (14) est conçu pour
- déplacer le premier élément à réluctance (13) sensiblement parallèlement au plan de la direction de déplacement des éléments de transport (21), et/ou
- le déplacer sensiblement perpendiculairement au plan de la direction de déplacement des éléments de transport (21), et/ou
- pour le faire tourner autour d'un axe (43) situé sensiblement dans le plan de la direction de déplacement des éléments de transport (21).

7. Système selon l'une des revendications précédentes, dans lequel le premier élément à réluctance (13) comprend des éléments en tôle stratifiés, lesquels sont orientés en particulier,
- dans la première position, sensiblement perpendiculairement au plan de la direction de déplacement des éléments de transport (21) et,
- dans la deuxième position, sensiblement parallèlement au plan de la direction de déplacement des éléments de transport (21).

8. Système selon l'une des revendications précédentes, dans lequel le premier élément à réluctance (13) est disposé au moins partiellement entre deux deuxièmes éléments à réluctance (12), dans lequel
- les deuxièmes éléments à réluctance (12) présentent une section transversale diminuant de manière continue dans une direction perpendiculaire au plan de la direction de déplacement des éléments de transport (21), dans lequel en particulier
- l'actionneur (14) est conçu pour déplacer le premier élément à réluctance (13) perpendiculairement au plan de la direction de déplacement des éléments de transport (21), et/ou
- le premier élément à réluctance (13) comprend une surface, laquelle correspond, au moins dans la deuxième position, de manière plane à une surface des deuxièmes éléments à réluctance (12).

9. Système selon l'une des revendications précédentes, dans lequel l'actionneur (14) comporte un moyen d'accumulation d'énergie, en particulier
- un ressort (68), et/ou
- un accumulateur d'énergie hydraulique et/ou
- pneumatique et/ou
- électrique.

10. Système de transport (100), comportant
- un système (90) selon l'une des revendications précédentes, et/ou
- un élément de transport (21) comportant
- un élément de support (1) et
- des aimants permanents (2), dans lequel
les aimants permanents (2) sont disposés sensiblement le long d'un plan d'une direction de déplacement de l'élément de transport (21) au-dessus du système (90) et produisent un motif magnétique, de telle sorte qu'en association avec les éléments à réluctance (12, 13) du système (90), un effet de force fortement dépendant de l'emplacement soit obtenu dans la direction du plan, dans lequel des différences, dépendant de l'emplacement, de l'effet de force sont amplifiées par le premier élément à réluctance (13) dans la deuxième position.
